# EUROPEAN PATENT APPLICATION

(11) **EP 2 996 238 A1**
(43) Date of publication of application: **16.03.2016**
(21) Application number: 14184116.3
(22) Date of filing: 09.09.2014
(51) Int. Cl.: H02M 7/00, H02M 7/49, H05K 7/14, H05K 7/20, H02M 7/483

(54) **Modular subsea converter**

(71) Applicant: ABB Technology Ltd, 8050 Zürich (CH)
(72) Inventor: Bolgiani, Fabio, 5242 Lupfig (CH); Lendenmann, Heinz, 722 18 Västerås (SE); Cagienard, Raphael, 5430 Wettingen (CH); Wagner, Thomas, 5506 Mägenwil (SE)
(74) Representative: Savela, Reino Aleksi

(57) **Abstract**

There is presented a modular subsea converter (35). The modular subsea converter (35) comprises a main housing (1), the main housing (1) being filled with a dielectric fluid (13). The modular subsea converter (35) comprises a bus bar (11), the bus bar (11) being provided within the main housing (1). The modular subsea converter (35) comprises at least one cell (2,2a), each cell (2,2a) comprising electrical equipment (9,9a,9b) and being electrically connectable to the bus bar (11). The modular subsea converter (35) comprises at least one individually removable portion (1a), each individually removable portion (1a) enabling individual replacement of one of the at least one cell (2,2a). There is also presented a replacement tool (21) for replacing a cell (2,2a) of such a modular subsea converter (35).

## Description

### TECHNICAL FIELD

The invention relates to subsea converters, and particularly to a modular subsea converter, and to a replacement tool for replacing a cell of such a modular subsea converter.

### BACKGROUND

In general terms, electric subsea installations and devices, such as subsea converters, usually demand high standards regarding durability, long-term functionality and independence during operation. Electric subsea installations that need to be cooled during operation, such as subsea converters, require an autonomous and durable cooling of its components. It is known to use a dielectric liquid of low compressibility such as for example mineral oil as a cooling fluid. The dielectric fluid could also be composed of natural or synthetic esters. In general terms, the dielectric fluid is used to provide a pressure compensated environment, and additionally functions as an electric insulation medium of electric components, such as capacitor units, placed in the electric installation.

The tanks of power-electronic subsea equipment, such as subsea converters, are thus typically filled with oil, which acts as a combined electric insulation and cooling medium.

During installation, the electrical equipment of the electric subsea installation is lifted as one part into an oil-filled tank cubicle (i.e., the subsea converter). Then the oil-filled tank cubicle is sealed and sunken to its operating location (i.e., at the seabed).

As the electrical equipment is placed inside an oil-filled medium voltage environment under high pressure at a perhaps very deep location it is impossible to disassemble the electric subsea installation in installed condition. A replacement of single occasional or isolated components of the electrical equipment is thus not considered. Hence, if maintenance or replacement of a defective component is required, the tank needs to be lifted up and opened such that any required work may be performed.

To lift up a complete tank may be very expensive and difficult (e.g., dependent on its weight and size). Moreover, systems that are intended to work in extreme environment, such as at the seabed, are commonly having very high requirements in terms of reliability which makes them generally more expensive and more complex.

Hence there is still a need for an electric subsea installation having replaceable electrical equipment.

### SUMMARY

An object of embodiments herein is to provide an electric subsea installation having replaceable electrical equipment.

Particularly, according to a first aspect there is presented a modular subsea converter. The modular subsea converter comprises a main housing, the main housing being filled with a dielectric fluid. The modular subsea converter comprises a bus bar, the bus bar being provided within the main housing. The modular subsea converter comprises at least one cell, each cell comprising electrical equipment and being electrically connectable to the bus bar. The modular subsea converter comprises at least one individually removable portion, each individually removable portion enabling individual replacement of one of the at least one cell. There is also presented a replacement tool for replacing a cell of such a modular subsea converter.

Advantageously, the modular subsea converter is suitable for an electric subsea installation, thus enabling the subsea installation to be provided with easily replaceable electrical equipment

Advantageously, the modular subsea converter enables efficient on site replacement of defective cells.

Advantageously, the modular subsea converter enables a replacement procedure to be carried out which may be cheaper than lifting up the subsea converter and then perform a reinstallation of defective cells.

Advantageously, the requirements on reliability of the subsea converter could be lowered.

Advantageously, the shut down time (if required) of the subsea converter can be shortened.

According to a second aspect there is presented a replacement tool for replacing a cell of a modular subsea converter according to the first aspect. The replacement tool is arranged to be hermetically docked to the modular subsea converter.

According to a third aspect there is presented a remotely operated underwater vehicle (ROV) comprising a replacement tool according to the second aspect.

It is to be noted that any feature of the first, second or third aspects may be applied to any other aspect, wherever appropriate. Likewise, any advantage of the first aspect may equally apply to the second aspect and/or the third aspect, and vice versa. Other objectives, features and advantages of the enclosed embodiments will be apparent from the following detailed disclosure, from the attached dependent claims as well as from the drawings.

Generally, all terms used in the claims are to be interpreted according to their ordinary meaning in the technical field, unless explicitly defined otherwise herein. All references to "a/an/the element, apparatus, component, means, step, etc." are to be interpreted openly as referring to at least one instance of the element, apparatus, component, means, step, etc., unless explicitly stated otherwise. The steps of any method disclosed herein do not have to be performed in the exact order disclosed, unless explicitly stated.

### BRIEF DESCRIPTION OF THE DRAWINGS

The invention is now described, by way of example, with reference to the accompanying drawings, in which:
Figure 1 schematically illustrates an oil-filled housing;
Figure 2 schematically illustrates a single MMC cell;
Figure 3 schematically illustrates an oil-filled housing;
Figure 4 schematically illustrates details of a single CHB cell;
Figures 5, 6, 7, and 8 schematically illustrate parts of a modular subsea converter according to embodiments;
Figure 9 schematically illustrates a replacement tool docked to a modular subsea converter according to an embodiment; and
Figure 10 is a schematic illustration of a remotely operated underwater vehicle comprising a replacement tool according to an embodiment.

### DETAILED DESCRIPTION

The invention will now be described more fully hereinafter with reference to the accompanying drawings, in which certain embodiments of the invention are shown. This invention may, however, be embodied in many different forms and should not be construed as limited to the embodiments set forth herein; rather, these embodiments are provided by way of example so that this disclosure will be thorough and complete, and will fully convey the scope of the invention to those skilled in the art. Like numbers refer to like elements throughout the description.

The present invention overcomes the issues of enabling efficient replacement of defective parts of an installed and/or operating subsea converter on site (i.e., without the need to lift the subsea converter from its operating position on the seabed) by providing the subsea converter with individually replaceable cells, each cell comprising electrical equipment.

In general, to be able to perform replacement of parts of an installed subsea converter, some boundary conditions may be needed to be considered. For example, some considerations may concern the environment; the seawater surrounding the subsea converter in operation may give rise to a pressure of up to in the region of about 310 bar. For example, some considerations may concern pressure compensation; the pressure difference from the inside to the outside of the housing of the subsea converter should to be minimal not only during operation (where it ideally is zero), but also during a replacement operation. For example, some considerations may concern sealing; in cases where the subsea converter is filled with a dielectric liquid, leakage of dielectric liquid into the surrounding environment (seawater) should be avoided, and may even be prohibited. For example, some considerations may concern the size of the cell which is intended to be replaceable. Therefore the design of the cell should allow the cell to be easily handled in the working environment of the subsea converter. For example, some considerations may concern materials; the materials that are exposed to seawater and/or dielectric liquid need to be chosen accordingly.

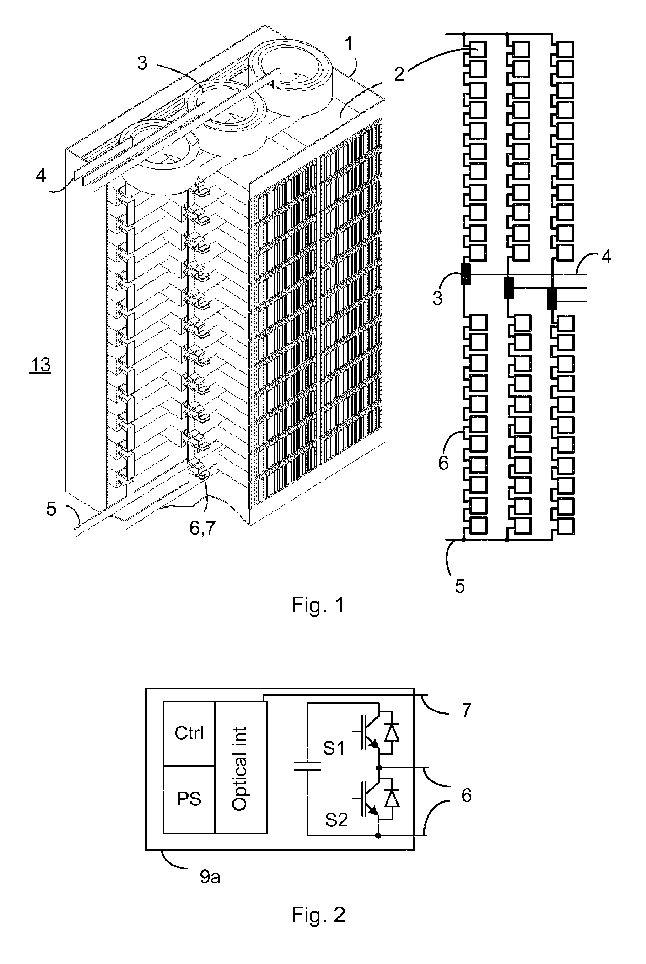

Figure 1 schematically illustrates an example of an oil-filled main housing 1 with openings for cells 2 as drawers. The main housing 1 is illustrated for an inverter for modular multilevel converter (MMC) topology. Further, in Figure 1 reference numeral 3 identifies a reactor, reference numeral 4 identifies a motor connection, reference numeral 5 identifies a connection to rectifier, reference numeral 6 identifies a power connection to a cell, reference numeral 7 identifies a signal/ auxiliary connection to a cell, and reference numeral 13 schematically illustrates a dielectric fluid, such as oil. In Figure 1 the rectifier is not shown for clarity purposes of the figure. Figure 2 schematically illustrates a single MMC cell 9a with connections 6, 7 and comprising transistors S1 and S2.

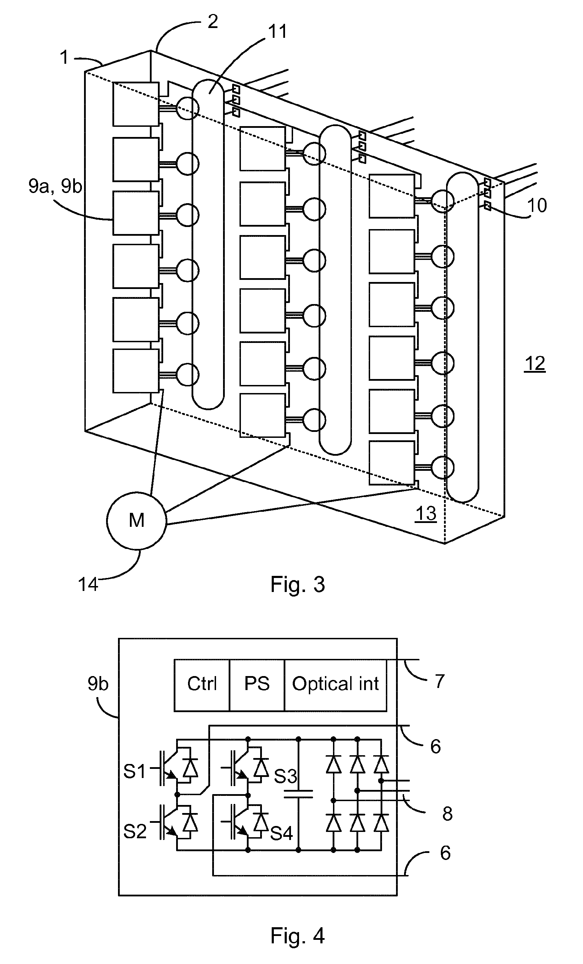

The same principle of having plugged connections on each cell could be also possible for different topologies such as the cascade H-bridge (CHB) topology. Figure 3 schematically illustrates a possible converter arrangement of an oil-filled main housing 1 with integrated transformers of a bus bar 11 where individual CHB cells 9a, 9b can be attached. The CHB cells are electrically connected to a motor (M) 14. The main housing 1 comprises penetrators 10 for enabling connection of components inside the tank to components outside the tank. According to the illustrative example of Figure 3 the main housing 1 comprises a total of nine penetrators 10; three penetrators for each column of CHB cells 9a, 9b. However, as is understood by the skilled person, the main housing 1 may comprise fewer than nine penetrators 10, such as only three penetrators 10, or even a single penetrator, wherein this single penetrator is configured for holding at least one cable (such as three cables) for enabling connection of components inside the tank to components outside the tank. The main housing 1 is arranged to be filled with a dielectric fluid 13, such as oil, and during operation be provided in an environment comprising seawater 12.

Figure 4 schematically illustrates details of a single CHB cell 9b with topology specific transformer connections 8 and comprising transistors S1, S2, S3, and S4.

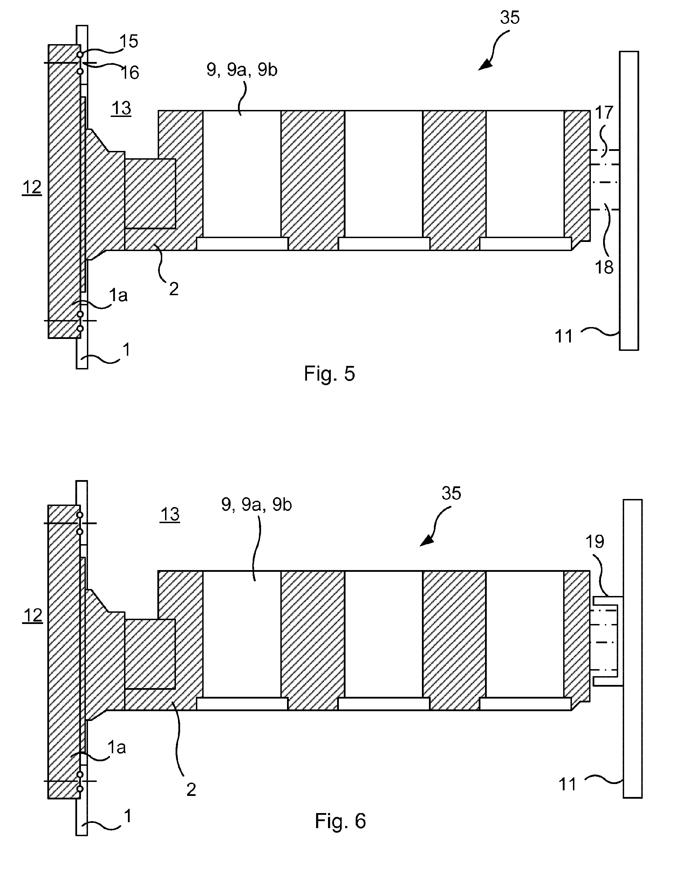

Reference is now made to Figures 5, 6, and 7. Figures 5, 6, and 7 are cross-sectional side views illustrating parts of a modular subsea converter according to embodiments.

In general terms, there is provided a modular subsea converter. The modular subsea converter 35 comprises a main housing 1. The main housing 1 is filled with a dielectric fluid 13. The dielectric fluid 13 may be oil. The modular subsea converter further comprises a bus bar 11. The bus bar 11 is provided within the main housing 1.

The modular subsea converter further comprises at least one cell 2. Each cell comprises electrical equipment 9, 9a, 9b. Examples of electrical equipment will be provided below. Each cell 2 is electrically connectable to the bus bar 11.

For this purpose the cell 2 and/or electrical equipment 9, 9a, 9b may comprise a power connection 18 and yet optionally a signal connection 17, such as a signal cable, such as an optical and/or electrical connection. The power connection may be an electrical connection such as a galvanic connection, an inductive connection 19, or a capacitive connection. The power connection and the signal connection may establish penetrable connections from the electric equipment 9, 9a, 9b through the cell 2 to the bus bar 11 of the main housing 1. The bus bar may thus be configured to provide electrical power to the electrical equipment. Each cell, including its electrical equipment, may be regarded as a component that is intended to be replaced as one part.

The main housing therefore comprises at least one individually removable portion 1a. Each individually removable portion corresponds to a respective one of the at least one cells 2. Each cell 2 may be provided within the main housing 1. The individually removable portions thereby enable individual replacement of each one of the at least two cells 2. Each individually removable portion may be regarded as cubicle box with openings to pull the cells out from (or into) the main housing 1. The inside of each such cubicle box may comprise a mechanical rack where the cells can be displaceably arranged.

Embodiments relating to further details of the modular subsea converter will now be disclosed.

In general terms, the modular subsea converter may comprise a plurality of cells, and the main housing may be provided with a plurality of individually removable portions, each corresponding to a respective cell.

Each cell may be attached to a respective one of the individually removable portions of the main housing. The cells and the individually removable portions may then be arranged such that removing one removable portion from the main housing results in one cell being disconnected from the bus bar and removed from the main housing.

There may be different ways to seal the removable portion to the main housing. For example, each removable portion may be sealed to the main housing by a seal, such as a double seal. Each seal may comprise at least one gasket 15. For example, a double seal may comprise two such gaskets. A vent may be provided between the gaskets to monitor tightness of the seal. For example, each removable portion may be fastened to the main housing by screws 16 and then sealed. Alternatively the each removable portion may be fastened to the main housing e.g. by welding.

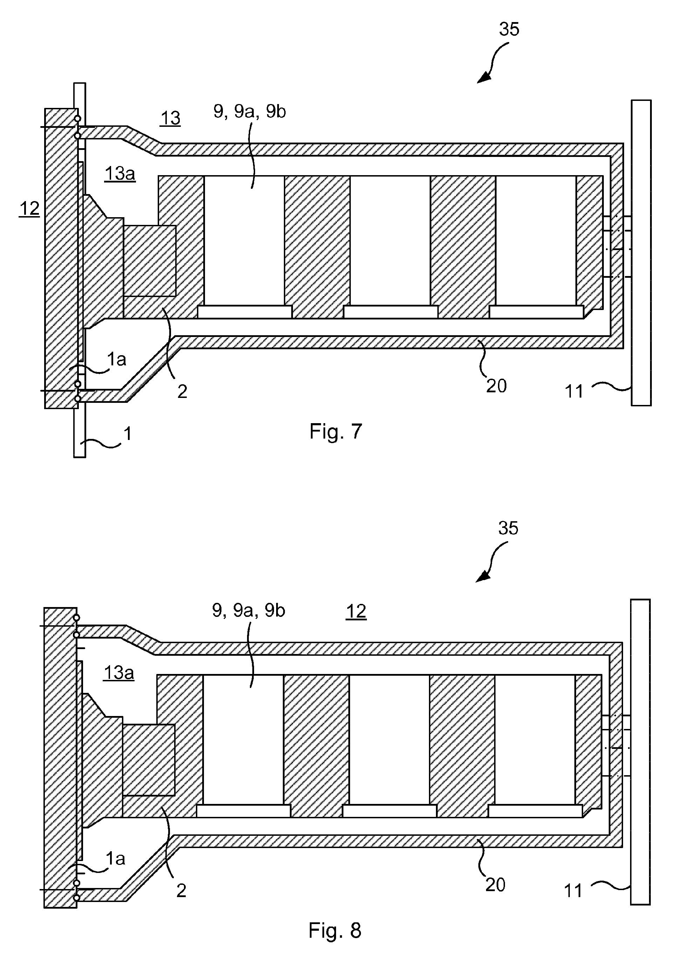

There may be different ways to provide the cells in the main housing. For example, each cell may be enclosed by an individual housing 20 in the main housing, as in the embodiments of Figure 7 and Figure 8. Each such individual housing may be pressure compensated. For example, each individual housing may be filled with a second dielectric fluid 13a. There are different examples of second dielectric fluid. As a first example, the second dielectric fluid in the individual housings is of same type as the dielectric fluid in the main housing. As a second example, the second dielectric fluid in the individual housings is of different type than the dielectric fluid in the main housing. Such individual housings may enable efficient control of dielectric fluid volume - and it would hence give the possibility to use a different kind of dielectric fluid than in the main housing.

Each individual housing 20 may be in contact with the dielectric fluid 13 of the main housing 1, as in the embodiment of Figure 7. Alternatively, each individual housing 20 may be in contact with seawater 12, as in the embodiment of Figure 8.

There are different types of electrical equipment 9, 9a, 9b that could be comprised in the cells. For example, the electrical equipment may be a transformer. Additionally or alternatively, each cell may correspond to one level of a cascade H-bridge (CHB) multilevel converter.

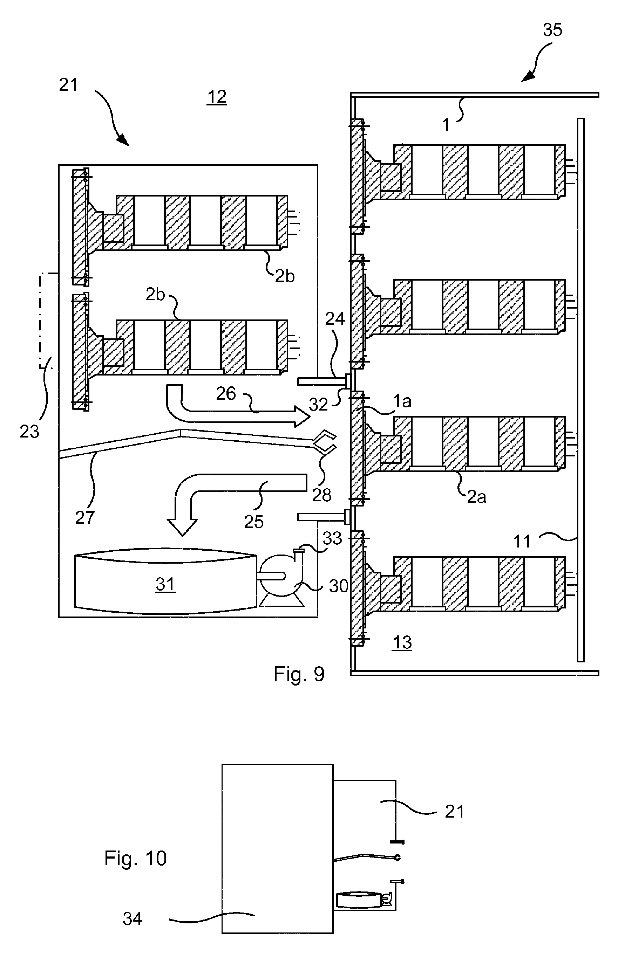

Reference is now made to Figures 9 and 10. Figure 9 is a cross-sectional side view illustrating an embodiment of parts of a replacement tool for replacing a cell of a modular subsea converter as herein disclosed. Figure 10 is a schematic illustration of a remotely operated underwater vehicle (ROV) comprising such a replacement tool.

In general terms, there is provided a replacement tool 21 for replacing a cell of a modular subsea converter as herein disclosed. The replacement tool is arranged to be hermetically docked to the modular subsea converter.

Embodiments relating to further details of the replacement tool will now be disclosed.

The replacement tool may comprise a docking portion 24. The docking portion may have an opening along a perimeter of the docking portion. The docking portion may be arranged to, at the perimeter, be docked to the individually removable portion (corresponding to the cell 2a to be replaced).

The replacement tool may comprise a pump 30. The pump may be arranged to empty the docking portion from a liquid, such as seawater, when the replacement tool is docked to the modular subsea converter. The pump may further be arranged to pump dielectric fluid into the chamber from a tank 31.

The replacement tool may comprise gripping means 27. The gripping means may be arranged to remove the individually removable portion and the cell 2a to be replaced from the main housing (by movement in the general direction indicated by arrow 25). The gripping means may further be arranged to attach a replacing cell 2b to the housing such that the replacing cell is electrically connected to the bus bar (by movement in the general direction indicated by arrow 26). The gripping means may further be arranged to reposition the individually removable portion to the main housing.

The pump may further be arranged to pump the dielectric fluid in the docking portion back to the tank.

There may be different ways to dock the docking portion to the individually removable portion of the main housing. For example, the replacement tool may further comprise fastening means 32. The fastening means may be arranged to attach the replacement tool to the modular subsea converter such that the docking portion is hermetically docked to the individually removable portion.

There may be different alternatives of where to keep the dielectric liquid of the replacement tool when it is not in the docking portion. As disclosed above, the tank may be provided for this purpose. The tank may be part of the replacement tool. Thus, the replacement tool may further comprise the tank.

There may be different dimensions and designs of the docking portion. For example, the docking portion may be configured such that it simultaneously can house the cell to be replaced 2a and at least one replacing cell 2b. For example, the docking portion may be configured such that it simultaneously can house at least two cells; one being a cell to be replaced, and one being the replacing cell.

There may be different ways to provide the gripping means. For example, the gripping means may extend through the docking portion. For example, the gripping means may comprise at least one mechanical arm. The at least one mechanical arm may be provided with a gripping hand 28.

The replacement tool may further be arranged to clean the dielectric fluid. For this purpose the replacement tool may comprise a filter 33 through which the dielectric fluid is passed when flowing between the docking portion and the tank. The replacement tool may further be arranged to exchange the dielectric fluid in the modular subsea converter. For this purpose the tank may be dimensioned such that it is enabled to hold all the dielectric fluid of one cell, or even all dielectric fluid of the entire modular subsea converter.

The replacement tool may comprise an interface 23 to a remotely operated underwater vehicle (ROV). Alternatively, the replacement tool may be part of a ROV 34, as in Figure 10. Hence, a ROV may comprise a replacement tool as herein disclosed.

Ways for replacing a cell in the modular subsea converter will now be disclosed.

Assume that the replacement tool has been docked to the modular subsea converter. Particularly, assume that the perimeter of the docking portion is docked to the individually removable portion corresponding to the cell to be replaced.

Once the replacement tool has been docked to the modular subsea converter the docking portion is by the pump of the replacement tool emptied from seawater (assuming that the modular subsea converter is placed in seawater).

Dielectric fluid is then by the pump of the replacement tool pumped into the docking portion from a tank, assuming the same fluid pressure as inside the main housing of the modular subsea converter.

The gripping means of the replacement tool then removes the cell to be replaced and places the cell to be replaced in the docking portion. In the modular subsea converter the gripping means replaces the cell to be replaced with the replacing cell such that the replacing cell is electrically connected to the bus bar of the modular subsea converter.

Once the cell has been replaced the modular subsea converter is sealed and then the dielectric fluid in the docking portion is pumped back to the tank.

The replacement tool is then undocked from the modular subsea converter.

The invention has mainly been described above with reference to a few embodiments. However, as is readily appreciated by a person skilled in the art, other embodiments than the ones disclosed above are equally possible within the scope of the invention, as defined by the appended patent claims. For example, although oil has been used as an example of the dielectric fluid, it is understood that any suitable dielectric fluid could be used.

## Claims

1. A modular subsea converter (35), comprising:
a main housing (1), the main housing being filled with a dielectric fluid (13);
a bus bar (11), the bus bar being provided within the main housing;
at least one cell (2, 2a), each cell comprising electrical equipment (9, 9a, 9b) and being electrically connectable to the bus bar; and
wherein the modular subsea converter comprises at least one individually removable portion (1a), each individually removable portion enabling individual replacement of one of the at least one cell.

2. The modular subsea converter according to claim 1, wherein each cell is attached to a respective one of the individually removable portions of the main housing.

3. The modular subsea converter according to claim 2, wherein the cells and the individually removable portions are arranged such that removing one removable portion from the main housing results in one cell being disconnected from the bus bar and removed from the main housing.

4. The modular subsea converter according to any one of the preceding claims, wherein the main housing further comprises at least one opening, each opening comprising a sealing interface, each removable portion being sealed against the sealing interface of a respective opening.

5. The modular subsea converter according to any one of the preceding claims, wherein each cell is enclosed by an individual housing (20).

6. The modular subsea converter according to claim 5, wherein each individual housing is pressure compensated.

7. The modular subsea converter according to claim 5 or 6, wherein each individual housing is filled with a second dielectric fluid (13a).

8. The modular subsea converter according to any one of the preceding claims, wherein each cell is provided within the main housing.

9. A replacement tool (21) for replacing a cell (2, 2a) of a modular subsea converter according to claim 1, the replacement tool being arranged to be hermetically docked to the modular subsea converter.

10. The replacement tool according to claim 9, further comprising a docking portion (24), the docking portion having an opening along a perimeter of the docking portion, and wherein the docking portion is arranged to, at said perimeter, be docked to the individually removable portion corresponding to the cell (2a) to be replaced.

11. The replacement tool according to claim 10, further comprising a pump (30) arranged to empty said docking portion from a liquid, such as seawater (12), when the replacement tool is docked to the modular subsea converter, and to pump dielectric fluid into the docking portion from a tank (31).

12. The replacement tool according to claim 11, wherein the pump further is arranged to pump dielectric fluid contained in the docking portion back to the tank.

13. The replacement tool according to claim 10, further comprising gripping means (27) arranged to remove said individually removable portion and said cell to be replaced from the housing, to attach a replacing cell (2b) to the housing such that said replacing cell is electrically connected to the bus bar, and such that said individually removable portion thereby is replaced.

14. The replacement tool according to claim 9, further comprising fastening means (32) arranged to attach the replacement tool to the modular subsea converter such that the docking portion is hermetically docked to the modular subsea converter.

15. The replacement tool according to any one of claims 9 to 14, wherein the replacement tool is configured to simultaneously house said cell to be replaced and at least one said replacing cell.

16. The replacement tool according to any one of claims 9 to 15, further comprising an interface (23) to a remotely operated underwater vehicle, ROV.

17. A remotely operated underwater vehicle, ROV, (34) comprising a replacement tool according to any one of claims 9 to 16.
